# EUROPÄISCHE PATENTSCHRIFT

(11) **EP 2 294 481 B1**
(45) Veröffentlichungstag und Bekanntmachung des Hinweises auf die Patenterteilung: **09.11.2011**
(21) Anmeldenummer: 09772000.7
(22) Anmeldetag: 25.06.2009
(51) Int. Cl.: G03B 15/03, G06T 5/50, H04N 5/235

(54) **VERFAHREN UND VORRICHTUNG ZUR ERZEUGUNG VON HIGH DYNAMIC RANGE (HDR)-BILDAUFNAHMEN SOWIE BELICHTUNGSVORRICHTUNGEN ZUR VERWENDUNG DARIN**
METHOD AND APPARATUS FOR PRODUCING HIGH DYNAMIC RANGE (HDR) PICTURES, AND EXPOSURE APPARATUSES FOR USE THEREIN
PROCÉDÉ ET DISPOSITIF DE PRODUCTION DE PRISES DE VUES À HAUTE PLAGE DYNAMIQUE (HDR), ET DISPOSITIFS D'ÉCLAIRAGE POUR SON UTILISATION

(30) Priorität: 02.07.2008 DE 102008031243
(43) Veröffentlichungstag der Anmeldung: 16.03.2011
(73) Patentinhaber: EADS Deutschland GmbH, 85521 Ottobrunn (DE)
(72) Erfinder: PEUSER, Peter, 85521 Riemerling (DE); SCHERTLER, Klaus, 85748 Garching (DE)
(74) Vertreter: Kastel, Stefan
(86) Internationale Anmeldenummer: PCT/DE2009/000877
(87) Internationale Veröffentlichungsnummer: WO 2010/000230

(56) Entgegenhaltungen:
- EP-A2- 1 308 767
- WO-A2-2006/007756
- US-A- 4 866 285
- US-A- 5 920 361
- US-A1- 2003 117 412
- US-A1- 2004 207 734
- US-A1- 2005 213 958
- US-A1- 2006 221 209
- US-A1- 2007 025 717
- US-A1- 2007 195 294
- US-A1- 2007 253 033
- US-B1- 6 239 828

## Beschreibung

Die Erfindung betrifft ein Verfahren und eine Vorrichtung zur Erzeugung von High Dynamic Range (HDR)-Bildaufnahmen. Außerdem betrifft die Erfindung vorteilhafte Belichtungsvorrichtungen zur Verwendung in einem solchen Verfahren und einer solchen Vorrichtung.

In der Fotografie und Bildverarbeitung ist die HDR-Bilderzeugung oder auch Dynamic Range Increase - oder DRI-Technik als Verfahren bekannt, mit welchem sich aus einer Serie von unterschiedlich belichteten Einzelbildern (Belichtungsserie) algorithmisch ein neues Bild mit sehr hohem Kontrastverhältnis erzeugen lässt.

Die HDR-Bilderzeugung oder auch Dynamic Range Increase-Technik genannt, wird in der Digitalfotografie verwendet, um den Dynamik-Umfang eines Bildes zu erhöhen.

Ziel des HDR-Bilderzeugungsverfahrens oder des DRI-Verfahrens ist es, den Gesamt-Kontrast eines Motivs mit großen Helligkeitsunterschieden auf einem Bild abzubilden und damit möglichst viele oder alle Details zu erhalten, wobei als Quelle mehrere Bilder mit geringerem Kontrastumfang als dem des Originalmotivs dienen.

Dabei werden mehrere Aufnahmen des exakt selben Bildausschnittes mit verschiedenen Belichtungszeiten gemacht. So entstehen bei den länger belichteten Aufnahmen überbelichtete Stellen, dafür sind aber auch schwach ausgeleuchtete Bereiche sichtbar. In den Aufnahmen mit den kürzeren Belichtungszeiten sind dagegen die hellen Stellen differenziert sichtbar, die schwach ausgeleuchteten Bereiche jedoch schwarz.

Diese einzelnen Aufnahmen werden nachträglich mit einem Bildbearbeitungsprogramm zusammengefügt, wobei jeweils die hellsten Stellen einer Aufnahme durch die aus der nächstdunkleren ersetzt werden. Dadurch erhält man ein Bild, welches einen höheren Kontrastbereich widerspiegeln kann und bei dem sowohl die hellsten als auch die dunkelsten Stellen in ihrer Struktur sichtbar sind.

Generell Schwierigkeiten bereiten Szenen mit bewegten oder sich bewegenden Objekten, wie z. B. laufenden Personen oder Tieren, flatternden Fahnen, etc.

Zum Beispiel werden zur Erzeugung einer Belichtungsserie nacheinander Aufnahmen mit Belichtungen von 1/125 Sekunden, 1/60 Sekunden, 1/30 Sekunden, 1/15 Sekunden usw. aufgenommen. Durch den darum erforderlichen langen Zeitbedarf zur Erzeugung der Belichtungsserie ergeben sich folgende Einschränkungen des Verfahrens:
- Die abgebildete Szene muss statisch sein.
- Die Szene darf beispielsweise keine sich bewegenden oder sich verformenden Objekte aufweisen (laufende Personen, Pflanzen im Wind, Wellen, usw. sind generell schwierig).
- Die Kamera muss statisch installiert sein, z. B. auf einem Stativ befestigt sein.

Aus der US 2003/0117412 A1 ist ein Verfahren zur Erzeugung von HDR-Bildaufnahmen gemäß dem Oberbegriff des beigefügten Anspruches 1 sowie eine Vorrichtung zur Durchführung dieses Verfahrens gemäß dem Oberbegriff des beigefügten Anspruches 7 bekannt. Diese Druckschrift beschreibt ein Verfahren zur Vergrößerung des dynamischen Lichtintensitätsbereiches eines Bildes durch die Beleuchtung einer Region mit Laserstrahlen mit unterschiedlicher Beleuchtungsintensität.

Aus der US 2007/0025717 A1 ist ein Verfahren zur Erzeugung von HDR-Bildaufnahmen bekannt, bei dem ein Satz von Bildern einer Szene, die bei unterschiedlichen Belichtungsbedingungen aufgenommen werden, erhalten werden. Der Satz von Bildern wird dann zum Erzeugen eines HDR-Bildes kombiniert.

Aus der US 2005/0213958 A1 ist ein Blitzgerät für eine Photokamera mit einer Halbleiterlaservorrichtung als Lichtquelle bekannt. Laserlichtstrahlen werden näherungsweise gleichmäßig durch eine Reflektorplatte gestreut.

Aus der US 4 866 285 ist eine Infrarotblitzeinheit für eine Kamera bekannt, die einen Infrarotfilm nutzt. Es ist ein Array von acht individuellen Reflektoren vorgesehen, die jeweils eine Laserdiode als Lichtquelle haben.

Aus der US 2004/0207734 A1 ist ein Bilderzeugungsgerät zum Erzeugen einer HDR-Bildaufnahme mit einer Steuerungseinheit bekannt.

Aus der US 2007/0253033 A1 ist ein Verfahren und eine Vorrichtung zur Verbesserung der Bildqualität in Bildern von monochromatischen Kameras unter Verwendung einer Belichtung mit mehreren Wellenlängen bekannt.

Aus der US 2006/0221209 A1 ist ein Kamerasystem bekannt, welches von einer Szene mit mehreren Optiken und mehreren Auflösungen unterschiedliche optische Daten erzeugt.

Aus der US 6 239 828 B1 ist eine Bilderzeugungseinheit für einen Laserstrahldrucker bekannt.

Aus der US 2007/0195294 A1 ist ein tragbarer Videoprojektor mit einer Einrichtung zum Ausrichten des projizierten Bildes je nach Zustand eines optischen Elements bekannt.

Eine weitere Bildprojektionseinheit ist aus der US 5 920 361 bekannt.

Aus der EP 1308 767 A2 ist ein Belichtungssystem und ein dieses verwendendes Projektionssystem bekannt.

Und aus der WO 2006/007756 A2 ist ein Laseroszillatorsystem bekannt.

Aufgabe der Erfindung ist es, HDR- oder DRI-Aufnahmen zu ermöglichen, bei denen auch bewegte Objekte leichter aufnehmbar sind und/oder bei denen auch die Kamera beweglich angeordnet sein kann.

Diese Aufgabe wird durch ein Verfahren mit den Schritten des beigefügten Patentanspruchs 1 sowie eine Vorrichtung zur Durchführung dieses Verfahrens mit den Merkmalen des beigefügten Patentanspruches 7 gelöst.

Vorteilhafte Ausgestaltungen der Erfindung sind Gegenstand der Unteransprüche.

Durch die Erfindung ist die Erzeugung von hochdynamischen Bildern (HDR- oder DRI-Bildern) durch ein bildgebendes System mit aktiver laserbasierter Beleuchtung ermöglicht.

Insbesondere lässt sich durch einen Laserbeleuchtungspuls, welcher mehrere Wellenlängen bei unterschiedlichen Intensitäten enthält, oder durch eine (vorzugsweise extrem schnelle) Abfolge von (vorzugsweise sehr kurzen) LaserlichtPulsen mit verschiedenen Intensitäten die Erzeugung von Bildserien mit einem im Vergleich zur Belichtungsserie im bisherigen bekannten Verfahren sehr kurzen Zeitbedarf realisieren, so dass keine Einschränkung in Bezug auf die Dynamik der Szene oder der Eigenbewegung der Kamera mehr vorliegt.

Damit wird beispielsweise eine DRI- oder HDR-Aufnahme von schnell bewegten, weit entfernten Objekten aus fliegenden Plattformen möglich.

Mittels Laserstrahlung von einer Laservorrichtung wird das aufzunehmende Objekt mit unterschiedlicher Intensität bestrahlt und zu jeder Intensität jeweils ein Einzelbild aufgenommen.

Durch unterschiedliche Intensitäten ist man unabhängig von Belichtungszeiten, so dass sich allein dadurch bereits ein erheblicher Zeitvorteil für die Bildaufnahme realisieren lässt.

Die Einzelbildaufnahme kann zeitlich nacheinander erfolgen, wozu bevorzugt eine Kamera mit extrem schneller Einzelbildaufnahme im Takt der Laserpulse verwendet wird.

Die Bildverarbeitungssoftware setzt das Gesamtbild aus den Einzelbildern wie im klassischen Verfahren zusammen, wobei eine Information über die Intensität, welche zur Aufnahme des jeweiligen Einzelbildes eingesetzt worden ist, benötigt wird.

Dies lässt sich gemäß einer Ausführungsform der Erfindung durch eine Messapparatur bewerkstelligen, die zeitgleich mit einem Teil der Strahlung zur Messung der Intensität versorgt wird.

Eine schnellere und zuverlässigere Information über die Intensitäten zwecks Bildbearbeitung erhält man, wenn die jeweiligen ausgesandten Intensitäten bereits bei der Aussendung entsprechend kodiert oder markiert werden.

Dies lässt sich bei einer vorteilhaften Ausgestaltung der Erfindung durch eine vorbestimmte Zeitabfolge erreichen, mit der Laserpulse bestimmter Intensitäten abgesandt werden. Der Empfangsteil wird dann mit der Information über die zeitliche Abfolge versorgt, so dass er den einzelnen nacheinander aufgenommenen Einzelbildern die jeweilige Intensität zuordnen kann.

Ein schnelleres Verfahren lässt sich dadurch erreichen, dass man den jeweiligen Intensitäten unterschiedliche Wellenlängen der auszusendenden Laserstrahlung zuordnet. Der Empfangsteil kann dann die Wellenlängen entsprechend ausfiltern und zu unterschiedlichen Aufnahmeeinrichtungen, insbesondere Kameras, lenken. Dadurch ist eine sehr kurze Aufnahme der Einzelbilder nacheinander, die nicht mehr so stark durch die Aufnahmegeschwindigkeit der Einzelkamera bestimmt wird, möglich.

Es ist aber auch möglich, die Wellenlängen mit unterschiedlichen Intensitäten gleichzeitig, beispielsweise in einem vereinigten Laserpuls abzusenden. Aufgrund der unterschiedlichen Wellenlänge lassen sich die unterschiedlichen Intensitäten dann unterschiedlichen Kameras zuordnen, die dann die entsprechenden Einzelbilder aufnehmen.

Die Teilstrahlung unterschiedlicher Wellenlänge lässt sich im Sendeteil z. B. ebenfalls durch eine Aufsplittung der Strahlung eines Lasers in unterschiedliche Teilstrahlung und entsprechende Wellenkonvertierung erreichen.

Andere Ausführungsformen für geeignete Laservorrichtungen zur Bereitstellung der als Lichtstrahlung zur Beleuchtung des aufzunehmenden Objektes eingesetzten Laserstrahlung weisen mehrere Laser, angeordnet in einer gemeinsamen Laservorrichtung, auf, die die unterschiedlichen Laserteilstrahlungen abstrahlen.

Besonders vorteilhaft lässt sich dies durch Diodenlaser erreichen, die auch sehr eng zusammen gestapelt werden können.

Bei dem zuvor erwähnten Verfahren, bei dem die Laserpulse unterschiedlicher Intensität nacheinander abgestrahlt werden, lässt sich ein Diodenlaser mit einer entsprechenden Strompulsfolge ansteuern. Vorteilhaft ist auch hierzu eine Diodenlaseranordnung mit entsprechend hoher Strahlleistung vorgesehen.

Bei der Ausbildung mit unterschiedlichen Wellenlängen lässt sich eine Anordnung aus Diodenlasern mit unterschiedlichen Emissionswellenlängen bilden. Unterschiedliche Intensitäten können durch unterschiedliche Dimensionierung der Diodenlasereinheiten - beispielsweise durch Vorsehen von unterschiedlichen Anzahlen von Diodenlaser-Barren, welche z. B. jeweils gestapelt angeordnet werden - erreichen.

Eine Pulslaserfolge mit wechselnder Intensität lässt sich alternativ auch beispielsweise durch einen Laseroszillator-Verstärker erreichen. Hierbei kann der Laseroszillator Laserpulse gleicher Wellenlänge und gleicher Intensität ausstrahlen. Der nachgeschaltete Laserverstärker wird mit zeitlich variierender Pumpenergie angesteuert, um die einzelnen Pulse dieser Pulsfolge unterschiedlich zu verstärken.

Ausführungsbeispiele der Erfindung werden nachfolgend anhand der beigefügten Zeichnung näher erläutert. Darin zeigt:
- Fig. 1: einen Sendeteil einer ersten Ausführungsform einer Vorrichtung zur Erzeugung von HDR- oder DRI-Bildaufnahmen in einem schematisierten Aufbau;
- Fig. 2: einen Graph mit einer beispielhaften Intensitätsverteilung der von dem Sendeteil nach Fig. 1 abgestrahlten Laserstrahlung;
- Fig. 3: ein Empfangsteil der ersten Ausführungsform der Vorrichtung zur Erzeugung von DRI- oder HDR-Bildaufnahmen in schematischer vereinfachter Darstellung;
- Fig. 4 u. 5: zwei Graphen, die Beispiele für in einem einzigen Laserpuls gleichzeitig gesendete Wellenlängenspektren mit unterschiedlichen Intensitäten bei unterschiedlichen Wellenlängen darstellen;
- Fig. 6: eine schematische Darstellung eines Sendeteils für eine zweite Ausführungsform der Vorrichtung zur DRI- oder HDR-Bilderzeugung;
- Fig. 7: eine schematische Darstellung einer einzelnen Diodenlasereinheit;
- Fig. 8: eine schematische Darstellung eines weiteren Ausführungsbeispiels eines Sendeteils für eine Vorrichtung zur DRI- oder HDR-Bilderzeugung, welche aus mehreren Diodenlasereinheiten nach Fig. 7 zusammengesetzt ist;
- Fig. 9: einen Graph, der eine Pulsfolge von Laserpulsen mit unterschiedlicher Amplitude als Beispiel für eine weitere zu Belichtungszwecke bei DRI-Bildaufnahmen oder HDR-Bildaufnahmen eingesetzte Laserstrahlung;
- Fig. 10: eine schematische Darstellung einer Laseroszillator-Laserverstärker-Vorrichtung, die als Sendeteil bei einer weiteren Ausführungsform der Vorrichtung zur HDR- oder DRI-Bilderzeugung verwendbar ist, und
- Fig. 11: einen Graphen zur Darstellung einer bei der Laseroszillator-Laserverstärker-Vorrichtung von Fig. 10 auf den Laserverstärker aufgebrachten sich zeitlich verändernden Pumpenergie.

Bei einer ersten Ausführungsform eines Verfahrens zur DRI- oder HDR-Bilderzeugung wird die typische Belichtungsserie der klassischen HDR (High Dynamic Range) -Bilderzeugung oder DRI (Dynamic Range Increase) - Bilderzeugung durch eine Abfolge von K in sehr kurzen Zeitabständen aufeinanderfolgenden kurzen Laserlichtpulsen ersetzt. Beispielsweise folgen die Laserlicht-Pulse im Nanosekunden oder Pikosekundenbereich aufeinander.

Bei der ersten Ausführungsform des Verfahrens besitzen die Einzelimpulse (N = 1...K) dabei unterschiedliche Wellenlängen λ_{N} (Farbkodierung) und Intensitäten I_{N} (Beleuchtungsstärke).

Beispielsweise steigt innerhalb der Pulsserie von Puls zu Puls die Intensität an (I_{N} ≥ I_{N+1}). Eine solche Pulsserie mit von Puls zu Puls ansteigender Intensität korrespondiert zu ansteigenden Belichtungszeiten im klassischen Verfahren, so dass eine gleichartige Bildbearbeitungssoftware wie ein klassisches Verfahren einsetzbar ist.

Durch die Aufnahme von K entsprechend der Wellenlänge λ_{N} spektral gefilterten Bildern des Rückstreulichts ist nun eine Zuordnung der so erzeugten Einzelbilder zu den ausgesendeten Intensitäten I_{N} möglich. Auf die Serie von K Einzelbildern mit bekannter Beleuchtungsstärke lassen sich nun die algorithmischen - grundsätzlich bekannten und in Form von Software auf dem Markt erhältlichen - Verfahren der HDR-Bilderzeugung oder DRI-Bilderzeugung anwenden.

Damit wird beispielsweise die HDR-Aufnahme von schnell bewegten Objekten aus fliegenden Plattformen möglich.

In einem alternativen Verfahren wird alternativ zur Verwendung einer Pulsfolge die Beleuchtung mit einem einzigen, besonders gestalteten Laserpuls durchgeführt, welcher unterschiedliche Wellenlängen mit unterschiedlichen Intensitäten enthält.

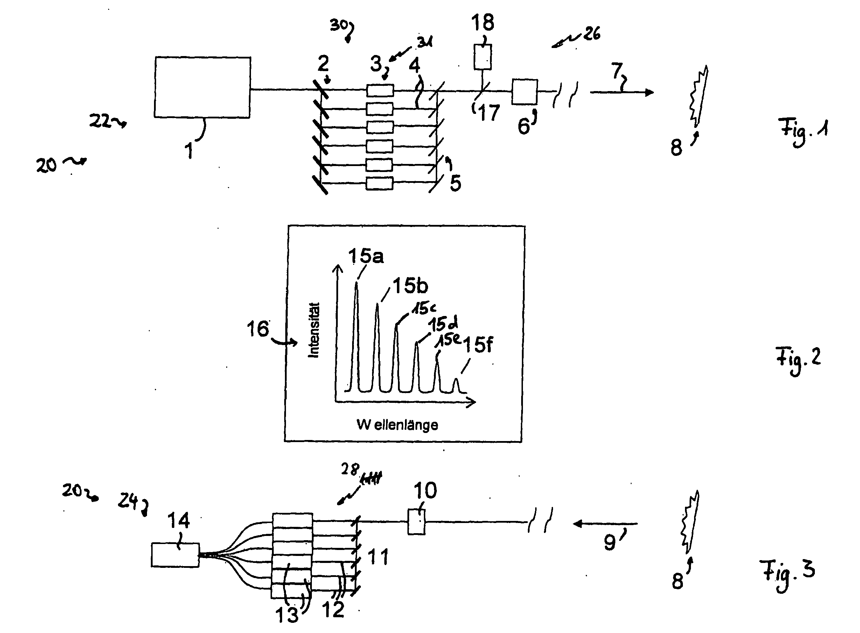

In den Figuren 1 und 3 ist eine Ausführungsform einer Vorrichtung 20 zur HDR-oder DRI-Bilderzeugung dargestellt. Die Vorrichtung 20 weist einen in Fig. 1 dargestellten Sendeteil 22 und einen in Fig. 3 dargestellten Empfangsteil 24 auf. Der Sendeteil weist eine Laservorrichtung 26 auf. Die Laservorrichtung 26 erzeugt in dem hier dargestellten Beispiel einen in Fig. 2 als Spektrum dargestellten Laserstrahl.

Der Empfangsteil 24 weist eine Aufnahmeeinrichtung 28 sowie eine Bildverarbeitungseinheit 14 auf.

In einer ersten Version der Vorrichtung 20 weist die Laservorrichtung 26 einen Kurzpulslaser 1 auf, der Strahlung mit Pulsbreiten im ns- oder ps-Bereich aussendet. Die Laservorrichtung 26 weist weiter eine spezielle Strahlformungsanordnung 30 auf, in der Pulssequenzen erzeugt werden, bei welchen jeder einzelne Puls 15a bis 15f eine andere Wellenlänge und eine unterschiedliche Intensität hat. Dabei liegen die Pulsabstände vorzugsweise im ns- oder ps-Bereich.

Mit einem solchen Laserstrahl 7 wird ein Messobjekt oder aufzunehmendes Objekt 8 angestrahlt. Das zurückreflektierte Licht - reflektierte Strahlung 9 - durchläuft eine optische Filteranordnung 11, welche die Strahlung 9 auf einzelne Messkanäle - Farbkanäle 12 - verteilt, so dass Strahlung jeweils einer einzigen Wellenlänge von einer zugeordneten Kamera 13 aufgenommen wird. Dadurch wird erreicht, dass jeweils einem Bild in einem Messzweig oder Messkanal eine bestimmte Aufnahme zugeordnet werden kann, welche mit einer bestimmten Beleuchtungsstärke aufgenommen worden ist. Die Pulsabstände sind dabei so klein, dass die einzelnen Aufnahmen quasi von einem stationären Objekt gewonnen werden. Aus den somit gewonnenen Einzel-Aufnahmen kann dann mittels geeigneter Bildverarbeitungsmethoden ein DRI- oder HDR-Bild erzeugt werden.

Bei einer zweiten Version der Vorrichtung 20 werden durch die Anwendung anderer Kurzpuls-Lasertechniken in einem einzigen Laserpuls mehrere Wellenlängen erzeugt, welche unterschiedliche Intensitäten haben.

Die Vorrichtung 20 weist demnach den Sendeteil 22 mit der Laservorrichtung 26 und einen Beleuchtungslaser auf. Der Empfangsteil 24 weist die Aufnahmeeinrichtung 28 - hier mit der optischen Filteranordnung 11 und den einzelnen Kameras 13 - und die Bildverarbeitungseinheit 14 auf.

Bei der in den Figuren 1 bis 3 dargestellten ersten Ausführungsform wird die Strahlung des Kurzpulslasers 1, der Laserpulse mit Pulsbreiten im ns- oder ps-Bereich emittiert, mittels Strahlteilern 2 unterschiedlicher Reflexion und Transmission für die Pumpstrahlung in mehrere Zweige aufgeteilt.

In dem Ausführungsbeispiel gemäß Fig. 1 ist dies für sechs Teilstrahlen 4 beispielhaft dargestellt, welche sechs Teilstrahlen 4 jeweils unterschiedliche Intensitäten haben. Jeder einzelne Teilstrahl 4 wird mittels optisch nicht linearer Materialien 3 wellenlängentransformiert, wobei unterschiedliche Wellenlängen erzeugt werden. Dies wird erreicht, indem optisch-nichtlinerare Prozesse genutzt werden. Beispielsweise können die Erzeugung höherer Harmonischer, die Konversion mittels optisch parametrischer Oszillatoren bzw. Generatoren, die Stimulierte Ramanstreuung oder Vierwellenmischungsprozesse genutzt werden, um die Primärstrahlung zu anderen Wellenlängen zu konvertieren.

Die auf diese Weise erhaltenen farblich unterschiedlichen Teilstrahlen 4 werden zu einem einzigen Laserstrahl 7 vereinigt, was beispielsweise mit einer einfachen Anordnung von Kantenfiltern 5 erreicht wird.

Die Intensitäten bei den verschiedenen Wellenlängen können auch auf einfache Weise mittels eines (nicht dargestellten) geeigneten Farbfilters eingestellt werden, welches in den Laserstrahl 7 eingefügt wird.

Um die für die Bildverarbeitung erforderlichen unterschiedlichen Beleuchtungsstärken bei den einzelnen Wellenlängen zu bestimmen, wird ein Bruchteil des Laserstrahls mit einem Strahlteiler 17 in eine Messeinheit 18 geleitet.

Der Laserstrahl 7 enthält nun eine Pulsfolge 16, welche sich aus Einzelpulsen 15a bis 15f zusammensetzt, die unterschiedliche Wellenlängen λ_{N} und unterschiedliche Intensitäten I_{N} aufweisen, wie dies in Fig. 2 dargestellt ist.

Die Divergenz des resultierenden Laserstrahls 7 kann mit einem geeigneten ersten Teleskop 6 angepasst werden, so dass das Objekt 8 optimal beleuchtet wird. Die Pulsfolgen können sich entsprechend der Repetitionsrate des Kurzpulslasers 1 wiederholen.

Wie in Fig. 3 dargestellt wird die vom Objekt 8 zurückreflektierte Strahlung 9 mit einem zweiten Teleskop 10 erfasst und anschließend mit einer Filteranordnung 11 in einzelne Farbkanäle 12 geleitet, die jeweils eine Kamera 13 enthalten, mit der die farblich kodierten Bilder aufgenommen werden.

Aus den Bildern der einzelnen Messkanäle oder Farbkanäle 12, welche mit unterschiedlichen Beleuchtungsstärken aufgenommen worden sind, kann nun mit der Bildverarbeitungseinheit 14 ein DRI-Bild oder HDR-Bild erzeugt werden.

Da die Laserstrahlung mit großen Intensitäten erzeugt werden kann, wobei eine große Photonenzahl bereitgestellt wird, können auch schwach reflektierende und/oder weit entfernte Objekte erfasst werden.

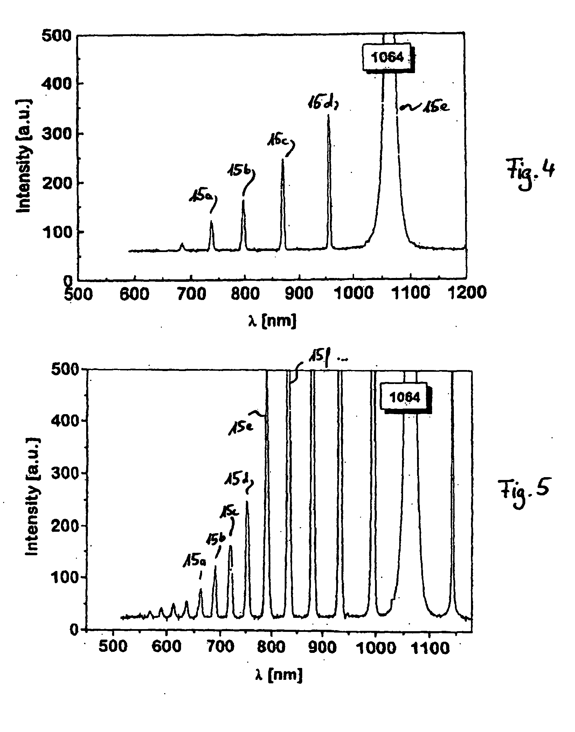

In einer nicht näher dargestellten, vom Grundaufbau jedoch sehr ähnlichen zweiten Ausgestaltung der Vorrichtung 20 erzeugt die als Sende- oder Beleuchtungslaser eingesetzte Laservorrichtung 26 mehrere Wellenlängen in einem einzigen Puls, wobei die Intensitäten bei diesen Wellenlängen unterschiedlich sind. Beispielsweise weist hierzu die Laservorrichtung 26 einen Multicolor-Laser auf. Bei einer solchen Anordnung mit einem Multicolor-Laser ist eine Aufspaltung des primären Laserstrahls in mehrere Zweige wie bei Fig. 1 nicht erforderlich. Beispielsweise nutzt ein solcher Multicolor-Laser den optisch nicht linearen Prozess der Stimulierten Raman-Streuung, bei dem aus einem Laserpuls einer bestimmten Wellenlänge mehrere diskrete Wellenlängen entstehen, welche je nach ihrer Ordnungszahl gemäß der sogenannten Stokes- oder Anti-Stokes-Linien unterschiedliche Intensitäten aufweisen, siehe hierzu im einzelnen J. Findeisen, H. J. Eichler, P. Peuser, A. A. Kaminskii, J. Hulliger; Appl. Phys. B 70 (2000) 159. Ein derartig erzeugter Laserpuls ist beispielhaft in der Fig. 4 als Spektrum-Diagramm dargestellt.

Ein anderes Beispiel ist in Fig. 5 dargestellt, wobei eine Wellenlängenfolge mit unterschiedlichen Intensitäten durch vier Wellenlängenmischungen erzeugt worden ist, siehe hierzu näher im Einzelnen J. Findeisen, Dissertation, TU Berlin, 1999, D83, Kap. 3, S. 39-40.

Als andere nichtlineare Prozesse können auch die Erzeugung früherer Harmonischer und/oder die Konversion mittels optisch parametrischer Oszillatoren bzw. Generatoren genutzt werden, um die Primärstrahlung zu anderen Wellenlängen zu konvertieren.

Für die Herstellung eines einzelnen Laserpulses, der unterschiedliche Wellenlängen bei unterschiedlichen Intensitäten enthält, kann weiterhin auch die Erzeugung von sog. "Chirped Pulses" genutzt werden, wobei die in einem ultrakurzen Puls enthaltenen Frequenzen bzw. Wellenlängen ein kontinuierliches Farbspektrum erzeugen, dessen Intensitätsverlauf in Abhängigkeit von der Wellenlänge auf einfache Weise, z. B. auch durch anschließende Farbfilterung, beeinflusst werden kann, so dass sich signifikante Intensitätsunterschiede im Wellenlängenspektrum ergeben. Die Herstellung von Chirped Pulses kann z. B. auf einfache Weise herbeigeführt werden, indem ein ultrakurzer Puls durch ein transparentes Medium geleitet wird.

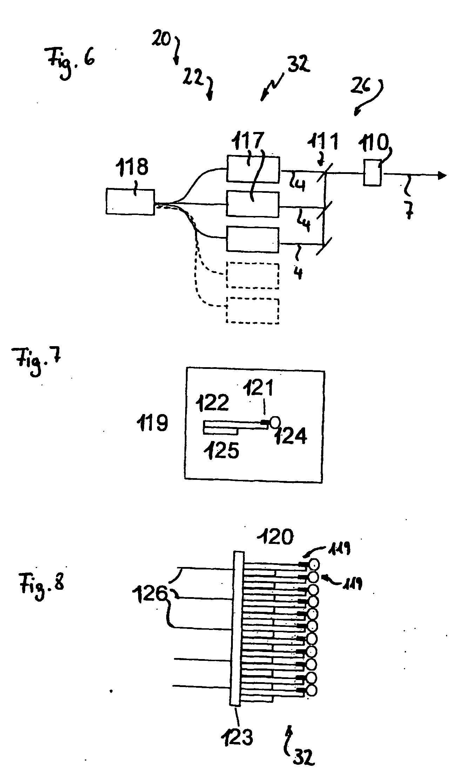

Als weitere Laser-Beleuchtungs-Strahlquellen, die in einem einzigen Beleuchtungspuls verschiedene Intensitäten bei unterschiedlichen Wellenlängen für DRI-oder HDR-Aufnahmen bereitstellen, sind auch Anordnungen von Halbleiterlasern mit hohen Leistungen geeignet, wie im folgenden näher anhand der Figuren 6 bis 8 näher erläutert wird.

In Fig. 6 ist eine weitere Ausführungsform der Laservorrichtung 26 dargestellt, die in einem Sendeteil 22 einer weiteren Ausführungsform der Vorrichtung 20 einsetzbar ist. Die Laservorrichtung 26 weist eine Anordnung 32 von mehreren Lasern, hier in Form von Hochleistungs-Diodenlasern 117 auf. Bei einer ersten Ausgestaltung dieser Anordnung 32 sind Diodenlaser 117 mit unterschiedlichen Emissionswellenlängen vorgesehen. Beispielsweise sind Diodenlaser vorgesehen, die auf 780 nm, 800 nm, 820 nm, 840 nm, etc... strahlen. Die Strahlungen unterschiedlicher Emissionswellenlängen werden jeweils mit unterschiedlichen Leistungen emittiert. Die Teilstrahlen 4 der einzelnen Diodenlaser 117 werden kollinear überlagert und zu einem einzigen Laserstrahl 7 vereinigt. Dies erfolgt beispielsweise mittels Kantenfiltern 111. Hierzu ist eine geeignete hohe Strahlqualität von Vorteil.

Diese kann für jeden einzelnen Diodenlaser 117 beispielsweise mit den gleichen Strahlformungstechniken erreicht werden, wie sie für die effiziente Einkopplung von Diodenlaserstrahlung hoher Leistung in eine optische Faser angewandt werden. So ist es beispielsweise möglich, Diodenlaserstrahlung mit mehr als 1 kW in eine optische Faser einzukoppeln. Für nähere Einzelheiten zu den anwendbaren Techniken wird auf P. Peuser et al., Opt. Lett. 31 (2006) 1991 verwiesen.

Bei der Ausführungsform gemäß Fig. 6 sind die einzelnen Diodenlaser 117 mit Hilfe einer gemeinsamen Steuereinheit 118 synchronisiert, so dass die Emission zeitgleich erfolgt. Die Pulslängen liegen typischerweise im Bereich von 110 µs bis zu einer ms. Größere Pulslängen sind möglich. Die verfügbaren Pulsenergien können dabei im Bereich bis zu ein J oder höher liegen, so dass eine große Zahl von Photonen bereitgestellt wird.

Es können aber auch andere Diodenlasertypen verwendet werden, die Pulsbreiten im Bereich von mehreren 10 ns oder 100 ns erzeugen. In diesem Falle ist die erreichbare Photonenzahl jedoch um Größenordnungen geringer. Weitere verfügbare Wellenlängenbereiche liegen bei etwa 900 nm bis 980 nm oder auch bei 1.500 nm. Dieser Wellenlängenbereich ist besonders günstig im Bezug auf augensicheren Betrieb.

Im folgenden wird unter Bezug auf die Figuren 7 und 8 eine neuartige kompakte Variante einer solchen Anordnung 32 von Hochleistungs-Diodenlasem 117 näher erläutert, die für die Anwendung als Beleuchtungsquelle in den hier vorgestellten Verfahren und Vorrichtungen besonders geeignet ist.

Um hohe Ausgangsleistungen bis in den kW-Bereich zu erzeugen, werden nach dem Stand der Technik mehrere sog. Diodenlaser-Barren 119 aufeinander gestapelt. Dies ist beispielsweise in P. Peuser, N. P. Schmitt; Diodengepumpte Festkörperlaser; Springer-Verlag, Heidelberg, 1995 näher erläutert, worauf ausdrücklich verwiesen wird. Für die Anwendung als DIR- oder HDR-Beleuchtungsstrahlquelle werden nun gemäß den Fig. 7 und 8 mehrere Diodenlaser-Barren 119 in einem gemeinsamen Stapel 120 vereinigt, welche unterschiedliche Emissionswellenlängen aufweisen. Typischerweise sind die Barren etwa 10 mm breit, wobei die Diodenlaserelemente 121 ("arrays") auf einem Träger 122 aufgebaut sind, über den die Verlustwärme zu einer gemeinsamen Wärmeableitungsplatte 123 geleitet wird.

Zur besseren Strahlformung werden, wie dies grundsätzlich im Stand der Technik bekannt ist, zusätzlich Mikro-Zylinderlinsen 124 aufgebracht. Die einzelnen Diodenlaser-Barren 119 sind durch Abstandselemente 125 voneinander getrennt. Die von den einzelnen Diodenlaser-Barren 119 emittierte Strahlung wird dann mit den geeigneten Strahlformungstechniken - siehe hierzu P. Peuser et al., Opl. Lett. 31 (2006) 1991 - zu einem einzigen Laserstrahl 7 zusammengefasst.

Durch eine unterschiedliche Anzahl von Diodenlaser-Barren 119 für jeden einzelnen Wellenlängenbereich können die bei jeder einzelnen Wellenlänge verfügbaren Diodenlaserleistungen bestimmt werden.

Alternativ oder zusätzlich können aber auch einzelne, durch ihre Wellenlänge charakterisierte Diodenlaser-Barren 119 oder Emissionsgruppen von Diodenlasern 117/119 mittels entsprechender Strom-Zuleitungen 126 separat angesteuert werden, so dass durch die Regelung des Diodenstroms die Emissionsleistung für jede einzelne Wellenlänge bestimmt wird.

Zuvorstehend wurden Ausführungsbeispiele für die Vorrichtung 20 zur DRI- oder HDR-Bilderzeugung beschrieben, bei denen die jeweils von der Laservorrichtung 26 abgestrahlten unterschiedlichen Intensitäten durch Farbkodierung unterschieden werden. Jedoch gibt es in jüngerer Zeit immer größere Entwicklungen auf dem Gebiet von Hochgeschwindigkeitskameras. Mit entsprechend schnellen Kameras 13 kann ggf. auf die Farb- bzw. Wellenlängenkodierung der beleuchtenden Strahlung verzichtet werden. Dies ist insbesondere dann der Fall, wenn die Kamera 13 hinreichend schnell solche Bilder differenzieren und aufnehmen kann, die mit Laserstrahlung beleuchtet wurden, die aus einer Sequenz von schnell aufeinander folgenden Pulsen besteht, welche unterschiedliche Leistungen aufweisen.

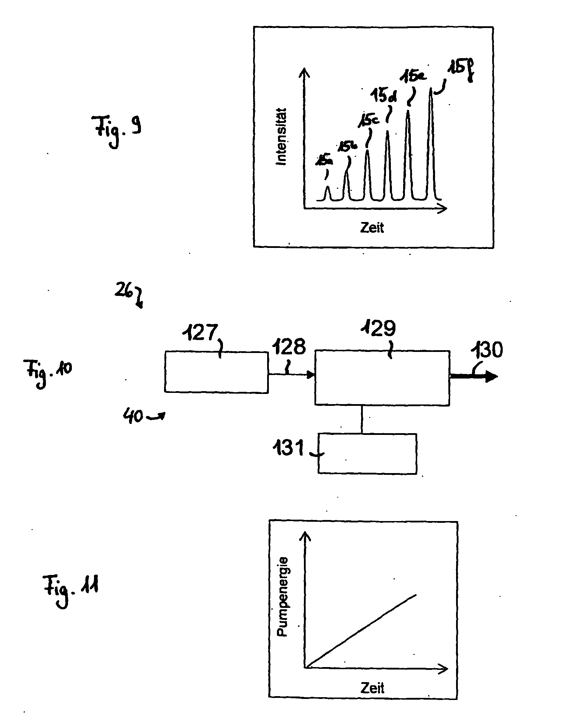

Geeignete Pulse können durch Anwendung entsprechender Lasertechniken nach dem Stand der Technik mit zeitlichen Abständen im Bereich von 10 µs bis zu mehreren ms bereitgestellt werden. Eine beispielhafte Pulsfolge ist in der Fig. 9 dargestellt.

Ein Beispiel für eine solche Laservorrichtung 26, welche die geeigneten Pulse erzeugen kann, ist in der Fig. 10 dargestellt. Dieses Ausführungsbeispiel für die Laservorrichtung 26 ist als Laseroszillator-Laserverstärker-Vorrichtung 40 ausgebildet. Diese Laseroszillator-Laserverstärker-Vorrichtung 40 weist einen Laseroszillator 127 und einen Laserverstärker 129 sowie eine Stromversorgungs- und Pulsformungseinheit 131 auf.

Von dem Laseroszillator 127 wird ein Laserstrahl 128 erzeugt, der eine Sequenz von mehreren Pulsen gleicher Amplitude erzeugt, z. B. mit Pulsbreiten im Bereich von 1 ns bis 500 ns.

Die Energie der einzelnen Pulse wird in dem danach angeordneten Laserverstärker 129 vergrößert.

Um die für die DRI- oder HDR-Aufnahmen notwendige Variation der Pulsamplituden in dem verstärkten Beleuchtungsstrahl 130 zu erreichen, wird die von der Stromversorgungs- und Pulsformungseinheit 131 bereitgestellte Pumpenergie des Laserverstärkers für die Dauer der Oszillator-Pulsfolge so variiert, dass die nacheinander, d. h. zu verschiedenen Zeiten, den Laserverstärker 129 durchlaufenden Pulse eine unterschiedliche Verstärkung erfahren. Ein Beispiel für einen hierbei in Frage kommenden Verlauf der Pumpenergie des Laserverstärkers 129 als Funktion der Zeit ist in der Fig. 11 dargestellt.

Weiter kann auch mit den oben beschriebenen Anordnungen 32 mehrerer Laser, insbesondere mit den oben beschriebenen Hochleistungs-Diodenlaserkonfigurationen, eine geeignete Pulsfolge mit zeitlich veränderter Leistung erzeugt werden.

Auch hierbei sind unterschiedliche Emissionswellenlängen nicht erforderlich. Die einzelnen Diodenlaser 117 oder Diodenlaser-Barren 119 können (müssen aber nicht) im gleichen Wellenlängenbereich emittieren. Durch zeitlich nacheinander an die einzelnen Diodenlaser 117, 119 angelegte Pumpstrom-Pulse mit unterschiedlicher Stromstärke lässt sich ein entsprechendes zeitliches Beleuchtungsprofil erzeugen. Solche Strompulse haben eine typische Länge von etwa 100 µs bis zu 1 ms, so dass die gesamte Pulsfolge eine Länge von einigen ms haben kann, was jedoch für die Belichtungszwecke ausreicht.

Dies gilt in gleichem Maße auch für die kompakte Variante, welche gemäß Fig. 8 als Stapel 120 aufgebaut ist. Hierbei werden dann die einzelnen Diodenlaser-Barren 119 separat angesteuert, so dass durch unterschiedliche, zeitlich nacheinander zur Anregung der Diodenlaser-Barren 119 applizierte Stromstärken entsprechend unterschiedliche Emissionsleistungen die Folge sind.

Hierbei ist es vorteilhaft, die einzelnen Teilstrahlen 4 vorzugsweise mit einer wie in P. Peuser et al., Opt. Lett. 31 (2006) 1991 beschriebenen optischen Konfiguration in eine Quarz-Mulitmode-Faser einzukoppeln. Beim Durchlaufen der optischen Pulse durch die Faser, welche typischerweise eine Länge von mehreren Metern hat, wird eine Homogenisierung der Intensitätsverteilung über dem Faserquerschnitt bewirkt. Anschließend wird die Strahlung mit einer geeigneten optischen Anordnung, beispielsweise einem Teleskop - erstes Teleskop 6 - zur Beleuchtung der aufzunehmenden Szene verwendet.

Das (nicht dargestellte) Empfangsteil einer solchen Vorrichtung 20, bei der die einzelnen Intensitäten rein durch Zeitabfolge identifiziert werden, würde sich durch eine entsprechend ausgebildete Hochleistungs-Kamera auszeichnen, die dann jeweils die nur mit einem der aufeinander folgenden Pulse belichteten Einzelbilder nacheinander aufnimmt.

### Bezugzeichenliste

- 1: Kurzpulslaser
- 2: Strahlteiler
- 3: optisch nicht-lineares Material
- 4: Teilstrahlen
- 5: Kantenfilter
- 6: erstes Teleskop
- 7: vereinigter Laserstrahl
- 8: Objekt
- 9: reflektierte Strahlung
- 10: zweites Teleskop
- 11: Filteranordnung
- 12: Farbkanäle
- 13: Kamera
- 14: Bildverarbeitungseinheit
- 15a: Einzelpuls
- 15b: Einzelpuls
- 15c: Einzelpuls
- 15d: Einzelpuls
- 15e: Einzelpuls
- 15f: Einzelpuls
- 16: Pulsfolge
- 17: Strahlteiler
- 18: Messeinheit
- 20: Vorrichtung
- 22: Sendeteil
- 24: Empfangsteil
- 26: Laservorrichtung
- 28: Aufnahmeeinrichtung
- 30: Strahlformungsanordnung
- 31: Wellenlängenkonvertereinrichtung
- 32: Anordnung mehrerer Laser
- 40: Laseroszillator-Laserverstärker-Vorrichtung
- 111: Kantenfilter
- 110: Teleskop
- 117: Diodenlaser
- 118: Steuereinheit
- 119: Diodenlaser-Barren
- 120: Stapel
- 121: Diodenlaserelemente
- 122: Träger
- 123: Wärmeableitungsplatte
- 124: Mikro-Zylinderlinsen
- 125: Abstandselement
- 126: Strom-Zuleitung
- 127: Laseroszillator
- 128: Laserstrahl
- 129: Laserverstärker
- 130: verstärkter Beleuchtungsstrahl
- 131: Stromversorgungs- und Pulsformungseinheit

## Patentansprüche

1. Verfahren zur Erzeugung von DRI- oder HDR-Bildaufnahmen, bei dem unterschiedlich belichtete Einzelbilder durch Bildbearbeitung zu einer HDR-Bildaufnahme zusammengefasst werden,
wobei die Belichtung mittels Laserstrahlung (7) mit unterschiedlicher Intensität erfolgt, **dadurch gekennzeichnet,**
**dass** Laserstrahlung (7) mit unterschiedlicher Wellenlänge derart erzeugt wird, dass Teilstrahlungen (4) auf unterschiedlichen Wellenlängen jeweils mit bestimmten unterschiedlichen Intensitäten abgestrahlt werden, und die so erzeugte Laserstrahlung (7) auf ein aufzunehmendes Objekt (8) gerichtet wird und
**dass** von dem mit der Laserstrahlung (7) belichteten Objekt (8) reflektierte Strahlung (9) nach Wellenlängen getrennt aufgenommen wird, um so Einzelbilder mit unterschiedlicher Beleuchtungsintensität zu erzeugen.

2. Verfahren nach Anspruch 1, **dadurch gekennzeichnet,**
**dass** die Laserstrahlung (7) unterschiedlicher Wellenlänge gemeinsam in einem Laserbeleuchtungspuls gesendet wird.

3. Verfahren nach einem der Ansprüche 1 oder 2, **dadurch gekennzeichnet, dass** ein aufzunehmendes Objekt (8) mit einer Folge von Laserpulsen mit unterschiedlicher Intensität belichtet wird, vorzugsweise derart,
a) dass die Laserpulse (15a-15f) in der Folge von Laserpulsen mit zeitlichen Abständen kleiner oder gleich etwa 1 ms, vorzugsweise mit zeitlichen Abständen im Nanosekundenbereich oder Picosekundenbereich, mehr bevorzugt mit zeitlichen Abständen von kleiner oder gleich etwa 100ns, gesendet werden; und/oder
b) dass Laserpulse (15a-15f) mit Pulsbreiten kleiner oder gleich 1 ms, vorzugsweise mit Pulsbreiten im Nanosekundenbereich oder Picosekundenbereich, mehr bevorzugt mit Pulsbreiten von kleiner oder gleich etwa 100ns, erzeugt und zur Belichtung verwendet werden.

4. Verfahren nach Anspruch 3, **dadurch gekennzeichnet,**
**dass** die Laserpulse (15a-15f) mit unterschiedlichen Wellenlängen und unterschiedlicher Intensität erzeugt werden, wobei zur DRI- oder HDR-Bildverarbeitung die Laserpulse bestimmter Intensität anhand ihrer Wellenlänge identifiziert werden.

5. Verfahren nach einem der Ansprüche 3 oder 4, **dadurch gekennzeichnet,**
**dass** die einander nachfolgenden Laserpulse (15a-15f) in einer bestimmten Reihenfolge mit unterschiedlicher Intensität erzeugt werden, wobei zur DRI- oder HDR-Bildverarbeitung die Laserpulse bestimmter Intensität mittels ihrer Zeitabfolge identifiziert werden.

6. Verfahren nach Anspruch 5, **dadurch gekennzeichnet,**
**dass** die Reihenfolge von Laserpulsen (15a-15f) unterschiedlicher Intensität mittels eines Laseroszillators (127) erzeugt wird, der zum Abgeben einer Sequenz von Laserpulsen (15a-15f) fähig ist, wobei die Amplitude der aufeinanderfolgenden Laserpulse (15a-15f)) aus dem Laseroszillator (127) anschließend in einem Laserverstärker (129) durch Veränderung einer Pumpenergie für den Laserverstärker variiert wird.

7. Vorrichtung (20) zur Erzeugung von DRI-oder HDR-Bildaufnahmen mit einer Aufnahmeeinrichtung (28) zum Aufnehmen von von einem aufzunehmenden Objekt (8) reflektierter Lichtstrahlung, welche Aufnahmeeinrichtung (28) zur Aufnahme von unterschiedlich belichteten Einzelbildern des Objekts (8) eingerichtet ist, und einer Bildbearbeitungseinheit (14) zur Erzeugung einer DRI- oder HDR-Bildaufnahme aus mehreren durch die Aufnahmeeinrichtung (28) aufgenommenen unterschiedlich belichteten Einzelbildern, mit einem Sendeteil (22) zum Aussenden von Lichtstrahlung (7) unterschiedlicher Intensität auf das aufzunehmende Objekt (8),
wobei der Sendeteil eine Laservorrichtung (26) aufweist, die eingerichtet ist, als Lichtstrahlung Laserstrahlung unterschiedlicher Intensität auf das Objekt (8) zu senden, **dadurch gekennzeichnet,**
**dass** die Laservorrichtung (26) zum Markieren und/oder Codieren von Laserteilstrahlung (4) unterschiedlicher Intensität ausgebildet ist und dass die Aufnahmeeinrichtung (28) eine Filteranordnung (11) aufweist, die von dem Objekt (8) reflektierte Strahlung (9) anhand der Markierung bzw. Codierung filtert, um jeweils Einzelbilder aus Laserstrahlung einer bestimmten Intensität aufzunehmen und
**dass** die Laservorrichtung (26) zum Markieren oder Codieren der Laserteilstrahlung unterschiedlicher Intensität Laserstrahlung unterschiedlicher Wellenlänge aussendet, wobei einer Wellenlänge eine Intensität zugeordnet ist, und dass die Filteranordnung (11) dazu eingerichtet ist, Laserteilstrahlung (4) unterschiedlicher Wellenlänge auszufiltern und daraus jeweils Einzelbilder zu erzeugen.

8. Vorrichtung nach Anspruch 7, **dadurch gekennzeichnet,**
**dass** die Laservorrichtung (26) zum Aussenden von Laserpulsen von maximal 1 ms, bevorzugt maximal etwa 100ns, in einem Pulsabstand von maximal 1 ms, bevorzugt maximal etwa 100ns, geeignet ist.

9. Vorrichtung nach Anspruch 8, **dadurch gekennzeichnet,**
**dass** die Laservorrichtung (26) zum Aussenden der Laserpulse mit unterschiedlicher Intensität eingerichtet ist.

10. Vorrichtung nach Anspruch 9, **dadurch gekennzeichnet,**
**dass** die Laservorrichtung (26) dazu eingerichtet ist, Laserpulse unterschiedlicher Wellenlänge derart auszusenden, dass die Laserpulse unterschiedlicher Wellenlänge jeweils mit unterschiedlichen Intensitäten ausgesandt werden.

11. Vorrichtung nach einem der Ansprüche 7-10, **dadurch gekennzeichnet,**
**dass** die Laservorrichtung (26) zum Aussenden eines Laserimpulses eingerichtet ist, der Lichtteilstrahlung unterschiedlicher Wellenlänge mit jeweils unterschiedlichen Intensitäten enthält.

12. Vorrichtung nach einem der Ansprüche 10 oder 11, **dadurch gekennzeichnet,**
**dass** die Laservorrichtung (26) einen Laser (1) zum Abstrahlen einer Primärstrahlung und wenigstens eine Wellenlängenkonvertereinrichtung (31) zum Verschieben eines Teils der Primärstrahlung zu einer anderen Wellenlänge aufweist.

13. Vorrichtung nach einem der Ansprüche 7-12, **dadurch gekennzeichnet,**
**dass** die Laservorrichtung (32) eine Anordnung (32) mehrerer Laser (117, 119) aufweist, um Laserteilstrahlung unterschiedlicher Intensität zu erzeugen, vorzugsweise derart,
a) **dass** die mehreren Laser (117, 119) zur Abstrahlung auf unterschiedlichen Wellenlängen eingerichtet sind und/oder
b) **dass** die mehreren Laser (117, 119) derart gesteuert sind, dass sie in einer bestimmten Zeitabfolge aussenden.

14. Vorrichtung nach einem der Ansprüche 7 bis 13, **gekennzeichnet durch** eine Diodenlaservorrichtung als Laservorrichtung (26) in dem Sendeteil (22), mit einer Anordnung (32) von mehreren Diodenlasern (117, 119), die vorzugsweise zu einem Stapel (120) gruppiert sind, wobei die Diodenlaser (117, 119) oder mehrere Gruppen von Diodenlaserelementen (121) zur Erzeugung von Laserstrahlung mit unterschiedlicher Intensität ausgebildet sind und wobei
a) die Diodenlaser (117, 119) unterschiedliche Emissionswellenlängen aufweisen und/oder
b) die Diodenlaser (117, 119) zur Abstrahlung in einer bestimmten zeitlichen Abfolge nacheinander angesteuert sind.

15. Vorrichtung nach einem der Ansprüche 7 bis 13, **gekennzeichnet durch** eine Laseroszillator-Laserverstärker-Vorrichtung (40) als Laservorrichtung (26) in dem Sendeteil (22), mit einem Laseroszillator (127) zur Erzeugung eines Laserstrahles (128), der eine Sequenz von mehreren Pulsen enthält, und
einem Laserverstärker (129) zur Verstärkung der von dem Laseroszillator (127) erzeugten Pulse sowie
einer Pumpquelle (131) für den Laserverstärker (129), die zum Versorgen des Laserverstärkers (129) mit einer sich zeitlich verändernden Pumpenergie ausgebildet ist, um die Pulse zeitlich variierend zu verstärken.

## Claims

1. Method for producing DRI or HDR pictures, in which differently exposed individual images are combined by image processing to form an HDR picture,
wherein the exposure is carried out by means of laser radiation (7) with a different intensity, **characterized in that**
laser radiation (7) is produced at a different wavelength such that radiation elements (4) at different wavelengths are each emitted with specific different intensities, and the laser radiation (7) produced in this way is directed at an object (8) to be recorded, and **in that**
radiation (9) reflected from the object (8) which has been exposed to the laser radiation (7) is recorded separated on the basis of wavelengths, in order in this way to produce individual images with a different illumination intensity.

2. Method according to Claim 1, **characterized in that** the laser radiation (7) at a different wavelength is sent jointly in one laser illumination pulse.

3. Method according to one of Claims 1 or 2, **characterized in that**
an object (8) to be recorded is exposed with a sequence of laser pulses with different intensity, preferably in such a way
a) that the laser pulses (15a-15f) are sent in the sequence of laser pulses with time intervals of less than or equal to about 1 ms, preferably with time intervals in the nanosecond range or picosecond range, and more preferably with time intervals of less than or equal to about 100 ns; and/or
b) that laser pulses (15a-15f) are produced with pulse widths of less than or equal to 1 ms, preferably with pulse widths in the nanosecond range or picosecond range, more preferably with pulse widths of less than or equal to about 100 ns, and are used for exposure.

4. Method according to Claim 3, **characterized in that** the laser pulses (15a-15f) are produced with different wavelengths and with different intensity, wherein the laser pulses of specific intensity are identified on the basis of their wavelength for DRI or HDR image processing.

5. Method according to one of Claims 3 or 4,
**characterized in that**
the successive laser pulses (15a-15f) are produced in a specific sequence with different intensity, wherein the laser pulses of specific intensity are identified by means of their time sequence for DRI or HDR image processing.

6. Method according to Claim 5, **characterized in that** the sequence of laser pulses (15a-15f) of different intensity is produced by means of a laser oscillator (127), which can emit a sequence of laser pulses (15a-15f), wherein the amplitude of the successive laser pulses (15a-15f) from the laser oscillator (127) is subsequently varied in a laser amplifier (129), by varying a pump energy for the laser amplifier.

7. Apparatus (20) for producing DRI or HDR pictures having a recording device (28) for recording light radiation reflected by an object (8) to be recorded, which recording device (28) is designed to record differently exposed individual images of the object (8), and having an image processing unit (14) for producing a DRI or HDR picture from a plurality of individual images which have been recorded by the recording device (28) and have been exposed differently, having
a transmitting part (22) for emitting light radiation (7) of different intensity to the object (8) to be recorded,
wherein the transmitting part has a laser apparatus (26) which is designed to send laser radiation of different intensity to the object (8), as light radiation, **characterized in that**
the laser apparatus (26) is designed for marking and/or coding of a laser radiation element (4) of different intensity, and **in that** the recording device (28) has a filter arrangement (11) which filters radiation (9) reflected by the object (8) on the basis of the marking or coding, in order to in each case record individual images from laser radiation of a specific intensity, and **in that**
the laser apparatus (26) transmits laser radiation at a different wavelength for marking or coding of the laser radiation element of different intensity, wherein a wavelength is associated with an intensity, and **in that** the filter arrangement (11) is designed to filter out the laser radiation element (4) at a different wavelength, and to produce individual images in each case from it.

8. Apparatus according to Claim 7, **characterized in that**
the laser apparatus (26) is suitable for transmitting laser pulses for a maximum of 1 ms, preferably for a maximum of about 100 ns, with a maximum pulse interval of 1 ms, preferably a maximum of about 100 ns.

9. Apparatus according to Claim 8, **characterized in that**
the laser apparatus (26) is designed to transmit the laser pulses with a different intensity.

10. Apparatus according to Claim 9, **characterized in that**
the laser apparatus (26) is designed to transmit laser pulses at a different wavelength such that the laser pulses at a different wavelength are each transmitted with different intensities.

11. Apparatus according to one of Claims 7-10,
**characterized in that**
the laser apparatus (26) is designed to transmit a laser pulse which contains a light radiation element at a different wavelength, in each case with different intensities.

12. Apparatus according to one of Claims 10 or 11,
**characterized in that**
the laser apparatus (26) has a laser (1) for emitting primary radiation and has at least one wavelength converter device (31) for shifting a portion of the primary radiation to a different wavelength.

13. Apparatus according to one of Claims 7-12,
**characterized in that**
the laser apparatus (32) has an arrangement (32) of a plurality of lasers (117, 119) in order to produce a laser radiation element at a different intensity, preferably in such a way
a) that the plurality of lasers (117, 119) are designed for emitting different wavelengths; and/or
b) that the plurality of lasers (117, 119) are controlled such that they transmit in a specific time sequence.

14. Apparatus according to one of Claims 7 to 13, **characterized by** a diode laser apparatus as a laser apparatus (26) in the transmitting part (22), having an arrangement (32) of a plurality of diode lasers (117, 119), which are preferably grouped to form a stack (120), wherein the diode lasers (117, 119) or plurality of groups of diode laser elements (121) are designed for producing laser radiation with a different intensity, and wherein
a) the diode lasers (117, 119) have different emission wavelengths, and/or
b) the diode lasers (117, 119) are operated successively for emission in a specific time sequence.

15. Apparatus according to one of Claims 7 to 13, **characterized by** a laser oscillator/laser amplifier apparatus (40) as a laser apparatus (26) in the transmitting part (22),
having a laser oscillator (127) for producing a laser beam (128) which contains a sequence of a plurality of pulses, and
a laser amplifier (129) for amplifying the pulses produced by the laser oscillator (127), and
a pump source (131) for the laser amplifier (129), which is designed to supply the laser amplifier (129) with pump energy which varies over time, in order to amplify the pulses such that they vary over time.

## Revendications

1. Procédé de prises de vues à haute plage dynamique DRI ou HDR selon lequel, on combine des prises de vues individuelles faites avec des exposition différente par le traitement des images pour obtenir une image HDR,
* l'exposition étant faite avec un faisceau laser (7) d'intensité différente,
procédé **caractérisé en ce qu'**
- on génère un faisceau laser (7) avec des longueurs d'onde différentes,
- les faisceaux partiels (4) à longueurs d'onde différentes sont émis chaque fois avec des intensités différentes, déterminées et on dirige le faisceau laser (7) sur l'objet (8) de la prise de vue, et
- on reçoit séparément le rayonnement (9) réfléchi par l'objet (8) éclairé par le faisceau laser (7) en fonction des longueurs d'onde pour obtenir ainsi des images séparées ayant une exposition différente.

2. Procédé selon la revendication 1,
**caractérisé en ce que**
le faisceau laser (7) avec des longueurs d'onde différentes, est émis en commun dans une impulsion d'éclairage laser.

3. Procédé selon la revendication 1 ou 2,
**caractérisé en ce que**
- l'objet (8) à saisir est éclairé avec une suite d'impulsions laser d'intensités différentes, de préférence **en ce que**,
a) on émet les impulsions laser (15a-15f) de la suite des impulsions laser avec des intervalles de temps inférieurs ou égaux à environ 1 ms, de préférence avec des intervalles de temps de l'ordre de la nanoseconde ou de la picoseconde et de manière plus préférentielle, avec des intervalles de temps inférieurs ou égaux à environ 100 ns, et/ou
b) on génère des impulsions laser (15a-15f) d'une largeur d'impulsions inférieure ou égale à 1 ms, de préférence avec des largeurs d'impulsions de l'ordre de la nanoseconde ou de la picoseconde et de manière plus préférentielle, avec des largeurs d'impulsions inférieures ou égales à environ 100 ns et on utilise ces impulsions pour l'exposition.

4. Procédé selon la revendication 3,
**caractérisé en ce que**
- on génère des impulsions laser (15a-15f) avec des longueurs d'onde différentes et des intensités différentes, et
- pour le traitement d'images à haute plage dynamique HDR ou DRI, on identifie les impulsions laser d'intensités déterminées à l'aide de leur longueur d'onde.

5. Procédé selon l'une des revendications 3 ou 4,
**caractérisé en ce qu'**
- on génère les impulsions laser (15a-15f) successives dans un ordre déterminé avec une intensité différente, et
- pour le traitement d'images DRI ou HDR, on identifie les impulsions laser d'intensités différentes par leur ordre chronologique.

6. Procédé selon la revendication 5,
**caractérisé en ce qu'**
on génère l'ordre des impulsions laser (15a-15f) d'intensités différentes à l'aide d'un oscillateur laser (127) permettant d'émettre une séquence d'impulsions laser (15a-15f),
* l'amplitude des impulsions laser (15a-15f) successives de l'oscillateur laser (127) étant ensuite modifiée dans un amplificateur laser (129) pour modifier l'énergie de pompage servant à l'amplification laser.

7. Dispositif (20) pour générer des prises de vues à haute plage dynamique DRI ou HDR avec une installation de prises de vues (28) pour recevoir le rayonnement lumineux réfléchi par l'objet (8) à prendre, cette installation de prises de vues (28) étant conçue pour faire des vues avec des expositions différentes de l'objet (8) et une unité de traitement d'images (14) pour former une image DRI ou HDR à partir de plusieurs vues séparées exposées différemment, prises par l'installation de prises de vues (28) comprenant une partie émetteur (22) pour émettre le faisceau lumineux (7) avec différentes intensités, dirigé sur l'objet (8) des prises de vues,
* la partie émetteur comportant un dispositif laser (26) conçu pour émettre comme faisceau lumineux, un faisceau laser d'intensités différentes, dirigé sur l'objet (8),
dispositif **caractérisé en ce que**
- le dispositif laser (26) marque et/ou code des faisceaux laser partiels (4) d'intensités différentes, et
- l'installation de prises de vues (28) comporte un dispositif de filtre (11) filtrant le rayonnement (9) réfléchi par l'objet (8) par le marquage ou le codage pour prendre chaque fois des images séparées correspondant à un faisceau laser d'intensité déterminée, et
- le dispositif laser (26) émet un faisceau laser de différentes intensités et de différentes longueurs d'onde pour marquer ou coder les faisceaux laser partiels,
* une longueur d'onde étant associée à une intensité, et
* le dispositif de filtre (11) est conçu pour séparer les faisceaux laser partiels (4) de longueurs d'onde différentes et former à partir de là des prises de vues séparées.

8. Dispositif selon la revendication 7,
**caractérisé en ce que**
- le dispositif laser (26) émet des impulsions laser d'une durée maximale de 1 ms, de préférence d'une durée maximale d'environ 100 ns avec un intervalle d'impulsion maximum de 1 ms, de préférence un intervalle maximum de 100 ns.

9. Dispositif selon la revendication 8,
**caractérisé en ce que**
le dispositif laser (26) émet des impulsions laser de différentes intensités.

10. Dispositif selon la revendication 9,
**caractérisé en ce que**
le dispositif laser (26) émet des impulsions laser de différentes longueurs d'onde,
- les impulsions laser de différentes longueurs différentes étant émises chacune avec une intensité différente.

11. Dispositif selon l'une des revendications 7 à 10,
**caractérisé en ce que**
- le dispositif laser (26) émet une impulsion laser qui correspond à un faisceau lumineux partiel de différentes longueurs d'onde et de différentes intensités.

12. Dispositif selon l'une des revendications 10 ou 11,
**caractérisé en ce que**
le dispositif laser (26) comporte un laser (1) pour émettre un rayonnement primaire et au moins une installation de conversion de longueur d'onde (31) pour décaler une partie du rayonnement primaire vers une autre longueur d'onde.

13. Dispositif selon l'une des revendications 7 à 12,
**caractérisé en ce que**
le dispositif laser (32) comporte un montage (32) de plusieurs lasers (117, 119) pour générer des faisceaux laser partiels de différentes intensités de préférence de façon que,
a) les différents lasers (117, 119) émettent un rayonnement de différentes longueurs d'onde, et/ou
b) les lasers (117, 119) sont commandés pour émettre dans un ordre déterminé.

14. Dispositif selon l'une des revendications 7 à 13,
**caractérisé par**
- un dispositif de diodes laser comme dispositif laser (26) dans la partie émetteur (22) avec un montage (32) de plusieurs diodes laser (117, 119) groupées de préférence en une pile (120),
* les diodes laser (117, 119) ou plusieurs groupes d'éléments de diodes laser (121) sont réalisés pour générer un faisceau laser de différentes intensités, et
a) les diodes laser (117, 119) ont des longueurs d'onde d'émission différentes, et/ou
b) les diodes laser (117, 119) sont commandées pour émettre successivement dans un ordre chronologique déterminé.

15. Dispositif selon l'une des revendications 7 à 13,
**caractérisé par**
- un dispositif oscillateur laser/amplificateur laser (40) comme dispositif laser (26) dans la partie émetteur (22) avec un oscillateur laser (127) générant un faisceau laser (128) comportant une séquence de plusieurs impulsions, et
- un amplificateur laser (129) pour amplifier les impulsions générées par l'oscillateur laser (127) ainsi que,
- une source de pompage (131) pour l'amplificateur laser (129) qui alimente l'amplificateur laser (129) avec une énergie de pompage variable dans le temps pour amplifier les impulsions de manière variable dans le temps.
